# EUROPEAN PATENT SPECIFICATION

(11) **EP 3 460 578 B1**
(45) Date of publication and mention of the grant of the patent: **26.10.2022**
(21) Application number: 18196329.9
(22) Date of filing: 24.09.2018
(51) Int. Cl.: G03F 7/30, H01L 21/67

(54) **SYSTEM FOR PROCESSING FLEXOGRAPHIC PRINTING PLATES**
VERFAHREN ZUM VERARBEITEN VON FLEXODRUCKPLATTEN
SYSTÈME DE TRAITEMENT DE PLAQUES D'IMPRESSION FLEXOGRAPHIQUE

(30) Priority: 25.09.2017 DK PA201770724
(43) Date of publication of application: 27.03.2019
(73) Proprietor: Glunz & Jensen A/S, 4100 Ringsted (DK)
(72) Inventor: Jensen, Peter, 4100 Ringsted (DK); Nedergaard, Stig, 4100 Ringsted (DK); Newman, Frank, 4100 Ringsted (DK)
(74) Representative: Budde Schou A/S

(56) References cited:
- WO-A1-97/46388
- DE-A1-102005 057 109
- GB-A- 2 435 253
- US-A- 1 817 332
- US-A- 6 012 193
- US-A1- 2007 006 406
- US-A1- 2016 236 239

## Description

### FIELD OF THE INVENTION

The present invention relates to a system for washing/cleaning flexographic printing plates. More specifically the invention relates to the development in several washing/cleaning stations utilizing oscillating rotating brushes in order to prepare the plates for use as printing plates in a printing operation.

### BACKGROUND OF THE INVENTION

In known apparatuses the printing plate to be treated contacts the liquid contained in a vessel, of which the wash-out quality steadily decreases as a consequence of the use of the active contents of the liquid and the pollution of the liquid by particles washed out or dissolved from the plates to be treated. Consequently this liquid has to be changed regularly. As a result thereof the quality of the liquid varies considerably so that it is possible that the plate to be treated is treated with a liquid, which is used and polluted considerably and that pollutions stay back on the plate thus treated. The quality of the delivered plates thus varies considerably.

In some known devices the printing plates are pulled through the device having rotating brushes to remove the photopolymers not polymerized during a previous exposure so that, depending on the design of the printing plate, at the end of the washing out process a positive or negative image remains in the form of relief on the printing plate.

Polymer particles adhering to the printing plates can impair the printed result achieved.

During the process a printing plate must be cleaned free of all polymer. Polymer particles adhering to the printing plates eventually lead to an accumulation of polymer/monomer particles on the brushes, or a deposit of particles inside the printing relief, which directly impacts the quality of the printed image. In addition, conventional brush-based processing suffers from substantially increased polymer and/or monomer concentration locally in the area where brush action is carried out. Such locally increased polymer/monomer concentration causes locally high viscosity and locally high saturation of the liquid, thus causing reduction of wash-out efficiency on the plate.

EP0410500 discloses a lithographic printing plate adapted for offset printing in which a pattern is formed in the printing plate by a photographic process. This pattern is formed by coating the plate with a light sensitive emulsion, exposing said emulsion and developing the image of the exposed emulsion. The developing process comprises different baths through which the plate passes successively and which have different purposes, such as fixation of the exposed image, washing off of chemicals, and surface treatment of the finished plate.

EP0623854 discloses an apparatus for processing a lithographic offset printing plate in such a process, which apparatus comprises different baths through which the plate is conveyed, controlled by suitable guide rollers. The guide rollers define a conveyor path guiding the plate down into the respective baths and up again, the plate being flexed in order to follow this course.

EP0415392 discloses a processing apparatus for processing a printing plate, provided with a bath and guide rollers which control the plate so that it is descended obliquely into the solution in the bath, flexed to follow a curved passage below the solution level and pulled upwardly out of the bath. The apparatus comprises a rotating brush roller, accommodated submerged in the solution, and a floating cover for shielding a portion of the surface of the solution, including the area above the brush. The purpose of the floating cover is to counteract the deterioration of the processing solution by the air.

Brushing generally enhances the processing process, but generally has an adverse effect on the useful life of many developer baths. Many processing chemicals are highly reactive and may exchange different gasses with the air, e.g. absorb CO2 or oxygen which react with chemicals in the baths so that these no longer have the desired effect and therefore must be reactivated or replaced. Movable brushes stirring the surface of the solution strongly accelerate this deterioration process.

US 4,952,961 discloses a machine for the treatment of printing plates which includes a plurality of rotating brushes of substantially cylindrical shape, over which a support table is slid in the longitudinal and transverse direction with a substantially random motion. The plate to be treated is secured under this support table, so that it is brushed by said cylindrical brushes. Also, the brushes are partially immersed in the liquids required for the treatment, solvents in particular, which are contained in suitable containers arranged under the brushes.

US 4,536,909 discloses an apparatus for treating flexible printing plates produced by a photochemical method, wherein the upper rollers of the first four pairs of rollers are covered with velour and the lower rollers of these pairs of rollers and both the rollers of the fifth pair of rollers are covered with a textile fabric. With this apparatus it is possible to continuously wash out and clean even flexible printing plates which are very tacky after exposure and have a high relief image.

WO0223277 discloses a machine for the treatment of printing plates, which includes a structure rotatably supporting a plurality of brushes of substantially cylindrical shape having their shafts mutually parallel and arranged with the axes thereof on a same plane parallel to a support table on which there is secured at least one printing plate to be treated. The brushes can be rotated by at least a first motor in order to brush a surface of the printing plate, where the support structure is eccentrically pivoted onto a support frame, so that it can be moved by a second motor with an orbital motion along a plane parallel to the support table.

A further example for an apparatus for the treatment of printing plates can be found in US6012193 A.

However, known systems cannot perfectly remove the non-polymerized portions, and in particular do not provide an even brushing of all the points of the surface and the relief of the printing plate to be treated. Moreover, known systems are complicated and bulky with high costs for manufacturing, maintenance and storing.

However, due to the uncontrolled motion of the support table, this known machine cannot perfectly remove the non-polymerized portions, and in particular does not provide an even brushing of all the points of the surface of the printing plate to be treated. Moreover, this known machine is complicated and bulky, whereby it has high costs for manufacturing, maintenance and storing.

Therefore the object of the present invention is to provide a machine free from said drawbacks. This object is achieved by means of a machine for the treatment of printing plates having the main characteristics disclosed in the first claim and other characteristics disclosed in the subsequent claims.

Therefore the object of the present invention is to provide a system free from said drawbacks. This object is achieved by means of a system for the treatment of printing plates in accordance with the claims.

### SUMMARY OF THE INVENTION

When washing or chemically processing a flexographic printing plate it is fed into a closed housing. The plate is then transported continuously through the closed housing by means of pairs of rollers or by being attached to a pin bar that is attached to a chain, and the washed out, cleaned and partially dried printing plate is then ready to be dried. The non-exposed material is washed out by means of brushes and the washout solution is normally fed to the brushes.

Thanks to the movement of the rotating brushes, the machine according to the present invention can perfectly remove all the non-polymerized portions from the printing plate. Moreover a linear oscillatory motion, which is preferably varying and synchronized with the motion of the brushes, ensures even treatment of the surface of the printing plate to be treated, without the risk of obtaining plate areas brushed differently from other areas.

Finally, the machine according to the present invention has an advantageously reduced complexity and bulkiness, thanks to the particular arrangement of the brushes, support table and mechanisms for the movement thereof.

The present invention is directed to a special configuration wherein cylindrical brushes are configured to be moved forth and back along their axis (axle or shaft onto which the brush material adheres). This rotating and oscillating movement of the brushes gives an excellent and consistent plate quality. This system is as such known from the prior art but the mechanics used to create this oscillating movement has been greatly simplified. This has eliminated unnecessary parts and increased reliability and serviceability providing the customer with a more robust and simplified unit. The oscillation system no longer features the old crank style actuator, and the noise associated with older geared systems has now been eliminated. The two sided oscillation is coupled with a chain that is connected to the rotation shafts.

Thus, in one aspect of the present invention there is provided a device for continuous washing-out of printing plates, with a continuous guide track and rotating and oscillating cylindrical brushes and devices for feeding washing-out fluid to the brushes.

The invention, in a first aspect, provides an apparatus for the processing of a printing plate, said apparatus comprising *tank* means adapted for containing a body of liquid, conveyor means adapted for guiding and conveying said plate along a conveying path which *path* comprises in succession an entry section in which said plate enters the apparatus, a treatment section in which said plate is treated by being exposed to liquid and mechanical treatment (rotating brushes), and an exit section in which the plate leaves the apparatus.

Specifically the present invention provides an apparatus for processing flexographic printing plates, said apparatus comprising:
- a frame;
- a support table attached to the frame on which the printing plates to be treated are conveyed;
- means for conveying the printing plates to be treated through the apparatus;
- a device for rinsing the printing plates with solvent;
- a first set of brushes of substantially cylindrical shape having their shafts mutually parallel and arranged with the axes and axles thereof on a same plane parallel to the support table, said brushes being rotatable in order to brush a surface of the printing plate, said first set of brushes being arranged with their axles coupled with means for oscillating the axles;
- a second set of brushes of substantially cylindrical shape, said second set of brushes interposed between the first set of brushes and having their shafts mutually parallel and arranged with the axes and axles thereof on a same plane parallel to the support table, said second set of brushes being rotatable in order to brush a surface of the printing plate, said second set of brushes being arranged with their axles coupled with means for oscillating the axles;
   said axles of the first set of brushes are suspended in the frame that is provided with holes for receiving the ends of the brushes and allowing linear movement of the axles, where the first ends of the axles of the first set of brushes extend to a first beam provided with a first transmission system connected to a first rotational motor, wherein the first beam is positioned on one the first exterior side of the frame and being moveable relative to the frame; and
   said axles of the second set of brushes are suspended in the frame that is provided with holes for receiving the ends of the brushes and allowing linear movement of the axles, where the second ends of the axles of the second set of brushes extend to a second beam provided with a first transmission system connected to a second rotational motor, wherein the second beam is positioned on the second exterior side of the frame and being moveable relative to the frame;
   wherein said first and second beams are movable with a linear oscillatory motion along the axis of the first and second set of brushes, said linear oscillatory motion enabled by a first and a second eccentric drive system coupled to a third motor.

In a preferred embodiment the eccentric drive systems are mounted on a frame below the first and second beams. It is also preferred that the first eccentric drive system mounted on the frame below the first beam is provided with a first drive axle connected to the third motor through a drive axle, said first drive axle further being provided with a first cog wheel and a chain that extends through the frame to engage with a second cog wheel below the second beam, said second cog wheel connected with a second drive axle forming part of the second eccentric drive system mounted on the frame below the second beam.

In order to obtain a smooth movement of the chain further cog wheels may be provided on the frame to engage with the chain. It is furthermore preferred that the frame is provided with holes for receiving the chain.

In order to obtain an efficient plate treatment it is preferred that the first and second set of brushes rotate in counter direction.

The device for washing the printing plates with solvent will in most embodiments of the present invention include a pump that supplies solvent for the treatment of the printing plates during rotation of the first and second set of brushes, said pump connected to a plurality of ducts or sprinklers arranged above the brushes parallel to the shafts thereof.

The apparatus is preferably also provided with a chiller unit and/or a rinse/wipe system to further enhance processing of the plates after treatment by the first and second set of rotating brushes.

The means for conveying the printing plates to be treated through the apparatus is preferably a chain system suspended in the direction of conveying the plates and onto which a pin bar can be mounted, said pin bar being attached to the plate to be treated during the process and removed afterwards.

### BRIEF DESCRIPTION OF THE DRAWINGS

Figure 1 shows a perspective view of the eccentric drive system.
Figure 2 shows an upper view of a part of the apparatus.
Figure 3 shows an upper view of the entire apparatus.

### DETAILED DESCRIPTION OF THE INVENTION

Referring to the drawings there is shown the apparatus of the present invention for processing a printing plate with a liquid.

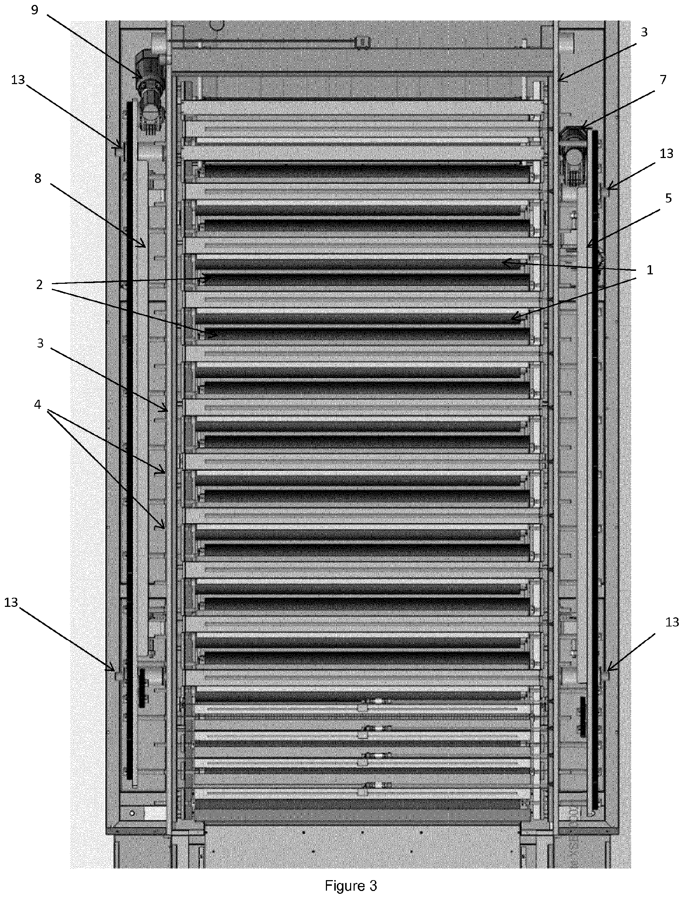

A first set (1) and a second set (2) of rotating brushes are shown in Figure 3, where the brushes are rotary driven by motors with separate transmission systems. In Figure 3 the apparatus is shown with a frame (3) that suspends the first set (1) and a second set (2) of rotating brushes. The axles (4) of the first set of brushes (1) are suspended in holes provided in the frame (3) allowing linear movement of the axles (4). The first ends of the axles of the first set of brushes extend to a first beam (5) provided with a first transmission system (6) connected to a first motor (7). The first beam (5) is moveable relative to the frame.

As can also be seen in Figure 3 the axles of the second set of brushes (2) are suspended in the frame (3) and allowing linear movement of the axles. The second ends of the axles of the second set of brushes (2) extend to a second beam (8) provided with a second transmission system connected to a second motor (9). The second beam (8) is also moveable relative to the frame.

The first (5) and second (8) beams are movable with a linear oscillatory motion along the axis of the first (1) and second (2) set of brushes, said linear oscillatory motion enabled by a first (10) and a second (11) eccentric drive system coupled to a third motor (12).

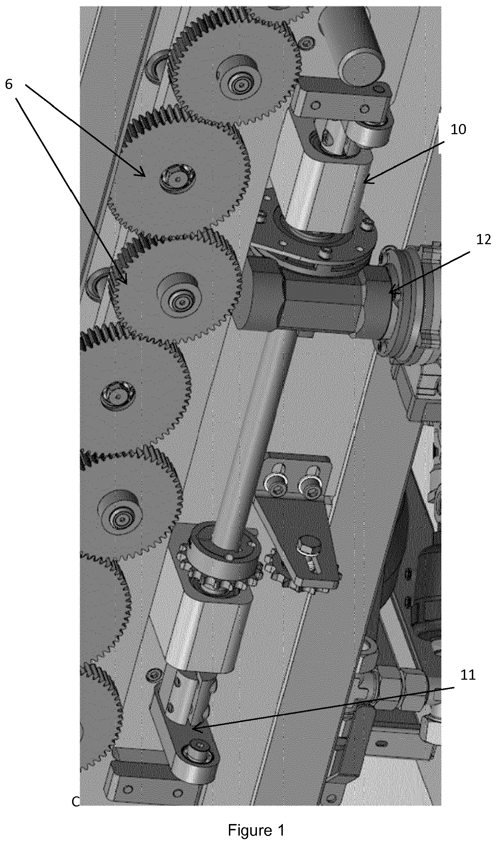

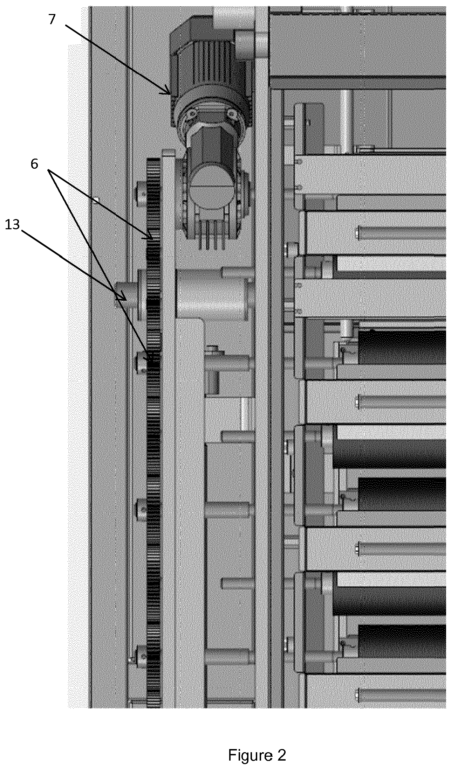

Figures 1 and 2 shows the part of the apparatus dealing with the first beam (5) and its associated eccentric drive system (11) coupled to the third motor (12). There is also shown a part of the first transmission system (6). In order to further stabilize the beams (5, 8) may be suspended (in holes, e.g. with bearings) on further supporting axles (13) allowing the linear movement.

## Claims

1. An apparatus for processing flexographic printing plates, said apparatus comprising:
- a frame (3);
- a support table attached to the frame (3) on which the printing plates to be treated are conveyed;
- means for conveying the printing plates to be treated through the apparatus;
- a device for rinsing the printing plates with solvent;
- a first set of brushes (1) of substantially cylindrical shape having their shafts mutually parallel and arranged with the axes and axles (4) thereof on a same plane parallel to the support table, said brushes (1) being rotatable in order to brush a surface of the printing plate, said first set of brushes (1) being arranged with their axles coupled with means for oscillating the axles;
- a second set of brushes (2) of substantially cylindrical shape, said second set of brushes (2) interposed between the first set of brushes and having their shafts mutually parallel and arranged with the axes and axles thereof on a same plane parallel to the support table, said second set of brushes (2) being rotatable in order to brush a surface of the printing plate, said second set of brushes (2) being arranged with their axles coupled with means for oscillating the axles;
said axles of the first set of brushes are suspended in the frame (3) that is provided with holes for receiving the ends of the brushes and allowing linear movement of the axles, where the first ends of the axles of the first set of brushes extend to a first beam (5) provided with a first transmission system (6) connected to a first motor (7), wherein the first beam is positioned on the first exterior side of the frame and being moveable relative to the frame; and
said axles of the second set of brushes (2) are suspended in the frame (3) that is provided with holes for receiving the ends of the brushes (2) and allowing linear movement of the axles, where the second ends of the axles of the second set of brushes (2) extend to a second beam (8) provided with a second transmission system connected to a second motor (9), wherein the second beam (8) is positioned on the second exterior side of the frame (3) and being moveable relative to the frame (3);
wherein said first (5) and second (8) beams are movable with a linear oscillatory motion along the axis of the first and second set of brushes, said linear oscillatory motion enabled by a first (10) and a second (11) eccentric drive system coupled to a third motor (12).

2. Apparatus according to claim 1, wherein the eccentric drive systems (10, 11) are mounted on the frame below the first (5) and second (8) beams.

3. Apparatus according to claim 1 or 2, wherein the first eccentric drive system (10) mounted on the frame below the first beam (5) is provided with a first drive axle connected to the third motor, said first drive axle further being provided with a first cog wheel and a chain that extends through the frame (3) to engage with a second cog wheel below the second beam, said second cog wheel connected with a second drive axle forming part of the second eccentric drive system (11) mounted on the frame (3) below the second beam (8).

4. Apparatus according to any one of the claims 1 to 3, wherein further cog wheels are provided on the frame to engage with the chain.

5. Apparatus according to any one of the claims 1 to 4, wherein the frame (3) is provided with holes for receiving the chain.

6. Apparatus according to any one of the claims 1 to 5, wherein the first and second set of brushes (1, 2) rotate in counter direction.

7. Apparatus according to any one of the claims 1 to 6, wherein the device for rinsing the printing plates with solvent comprises a pump that supplies the solvent for the treatment of the printing plates during rotation of the first and second set of brushes (1, 2), said pump connected to a plurality of ducts or sprinklers arranged above the brushes parallel to the shafts thereof.

8. Apparatus according to any one of the claims 1 to 7, wherein the apparatus is further provided with a chiller unit.

9. Apparatus according to any one of the claims 1 to 8, wherein the apparatus is further provided with a rinse/wipe system to further enhance processing of the plates after treatment by the first and second set of rotating brushes (1, 2).

10. Apparatus according to any one of the claims 1 to 9, wherein means for conveying the printing plates to be treated through the apparatus is a chain system suspended in the direction of conveying the plates and onto which a pin bar can be mounted, said pin bar being attached to the plate to be treated during the process and removed afterwards.

## Patentansprüche

1. Vorrichtung zum Verarbeiten von Flexodruckplatten, wobei die Vorrichtung Folgendes umfasst:
- einen Rahmen (3);
- einen am Rahmen (3) angebrachten Auflagetisch, auf dem die zu behandelnden Druckplatten befördert werden;
- Mittel zum Befördern der zu behandelnden Druckplatten durch die Vorrichtung;
- eine Vorrichtung zum Spülen der Druckplatten mit Lösungsmittel;
- einen ersten Satz von Bürsten (1) mit im Wesentlichen zylindrischer Form, deren Wellen zueinander parallel sind und deren Mittellinien und Achsen (4) auf einer gleichen Ebene parallel zum Auflagetisch angeordnet sind, wobei die Bürsten (1) drehbar sind, um eine Oberfläche der Druckplatte zu bürsten, wobei der erste Satz von Bürsten (1) so angeordnet ist, dass dessen Achsen mit Mitteln zum Oszillieren der Achsen gekoppelt sind;
- einen zweiten Satz von Bürsten (2) mit im Wesentlichen zylindrischer Form, wobei der zweite Satz von Bürsten (2) zwischen dem ersten Satz von Bürsten angeordnet ist und seine Wellen zueinander parallel und deren Mittellinien und Achsen auf einer gleichen Ebene parallel zu dem Auflagetisch angeordnet sind, wobei der zweite Bürstensatz (2) drehbar ist, um eine Oberfläche der Druckplatte zu bürsten, wobei der zweite Satz von Bürsten (2) so angeordnet ist, dass dessen Achsen mit Mitteln zum Oszillieren der Achsen gekoppelt sind;
wobei die Achsen des ersten Satzes von Bürsten in dem Rahmen (3) aufgehängt sind, der mit Löchern zum Aufnehmen der Bürstenenden und zum Ermöglichen einer linearen Bewegung der Achsen bereitgestellt ist, wobei sich die ersten Enden der Achsen des ersten Satzes von Bürsten zu einem ersten Balken (5) erstrecken, der mit einem ersten Übertragungssystem (6) bereitgestellt ist, das mit einem ersten Motor (7) verbunden ist, wobei der erste Balken an der ersten Außenseite des Rahmens positioniert und relativ zum Rahmen beweglich ist; und
wobei die Achsen des zweiten Satzes von Bürsten (2) in dem Rahmen (3) aufgehängt sind, der mit Löchern zum Aufnehmen der Bürstenenden (2) und zum Ermöglichen einer linearen Bewegung der Achsen bereitgestellt ist, wobei sich die zweiten Enden der Achsen des zweiten Satzes von Bürsten (2) zu einem zweiten Balken (8) erstrecken, der mit einem zweiten Übertragungssystem bereitgestellt ist, das mit einem zweiten Motor (9) verbunden ist, wobei der zweite Balken (8) an der zweiten Außenseite des Rahmens (3) positioniert und relativ zum Rahmen (3) beweglich ist;
wobei der erste (5) und der zweite (8) Balken mit einer linearen Oszillationsbewegung entlang der Achse des ersten und des zweiten Satzes von Bürsten beweglich sind, wobei die lineare Oszillationsbewegung durch ein erstes (10) und ein zweites (11) Exzenterantriebssystem ermöglicht wird, das mit einem dritten Motor (12) gekoppelt ist.

2. Vorrichtung nach Anspruch 1, wobei die Exzenterantriebssysteme (10, 11) auf dem Rahmen unterhalb des ersten (5) und zweiten (8) Balkens montiert sind.

3. Vorrichtung nach Anspruch 1 oder 2, wobei das erste Exzenterantriebssystem (10), das an dem Rahmen unterhalb des ersten Balkens (5) montiert ist, mit einer ersten Antriebsachse bereitgestellt ist, die mit dem dritten Motor verbunden ist, wobei die erste Antriebsachse ferner mit einem ersten Zahnrad und einer Kette bereitgestellt ist, die sich durch den Rahmen (3) erstreckt, um in ein zweites Zahnrad unterhalb des zweiten Balkens einzugreifen, wobei das zweite Zahnrad mit einer zweiten Antriebsachse verbunden ist, die einen Teil des zweiten Exzenterantriebssystems (11) bildet, das auf dem Rahmen (3) unterhalb des zweiten Balkens (8) montiert ist.

4. Vorrichtung nach einem der Ansprüche 1 bis 3, wobei weitere Zahnräder an dem Rahmen bereitgestellt sind, um mit der Kette in Eingriff zu kommen.

5. Vorrichtung nach einem der Ansprüche 1 bis 4, wobei der Rahmen (3) mit Löchern zum Aufnehmen der Kette bereitgestellt ist.

6. Vorrichtung nach einem der Ansprüche 1 bis 5, wobei sich der erste und der zweite Satz von Bürsten (1, 2) in entgegengesetzter Richtung drehen.

7. Vorrichtung nach einem der Ansprüche 1 bis 6, wobei die Vorrichtung zum Spülen der Druckplatten mit Lösungsmittel eine Pumpe umfasst, die das Lösungsmittel zur Behandlung der Druckplatten während dem Drehen des ersten und zweiten Bürstensatzes (1, 2) zuführt, wobei die Pumpe mit mehreren Kanälen oder Sprinklern verbunden ist, die über den Bürsten parallel zu deren Wellen angeordnet sind.

8. Vorrichtung nach einem der Ansprüche 1 bis 7, wobei die Vorrichtung ferner mit einer Kühleinheit versehen ist.

9. Vorrichtung nach einem der Ansprüche 1 bis 8, wobei die Vorrichtung ferner mit einem Spül-/Wischsystem zur weiteren Verbesserung der Bearbeitung der Platten nach Behandlung durch den ersten und zweiten Satz rotierender Bürsten (1, 2) bereitgestellt ist.

10. Vorrichtung nach einem der Ansprüche 1 bis 9, wobei die Mittel zum Befördern der zu behandelnden Druckplatten durch die Vorrichtung ein Kettensystem ist, das in Beförderungsrichtung der Platten aufgehängt ist und an dem eine Nadelstange angebracht werden kann, wobei die Nadelstange während des Prozesses an der zu behandelnden Platte angebracht und danach entfernt wird.

## Revendications

1. Appareil de traitement de plaques d'impression flexographique, ledit appareil comprenant :
- un châssis (3) ;
- une table de support fixée au châssis (3) sur laquelle les plaques d'impression à traiter sont acheminées ;
- un moyen pour acheminer les plaques d'impression à traiter à travers l'appareil ;
- un dispositif de rinçage des plaques d'impression avec du solvant ;
- un premier ensemble de brosses (1) de forme sensiblement cylindrique ayant leurs arbres mutuellement parallèles et agencés avec leurs axes et essieux (4) sur un même plan parallèle à la table de support, lesdites brosses (1) pouvant tourner pour brosser une surface de la plaque d'impression, ledit premier ensemble de brosses (1) étant agencées avec leurs essieux couplés à un moyen pour faire osciller les essieux ;
- un second ensemble de brosses (2) de forme sensiblement cylindrique, ledit second ensemble de brosses (2) étant intercalées entre le premier ensemble de brosses et ayant leurs arbres mutuellement parallèles et agencés avec les axes et essieux de celles-ci sur un même plan parallèle à la table de support, ledit second ensemble de brosses (2) pouvant tourner afin de brosser une surface de la plaque d'impression, ledit second ensemble de brosses (2) étant agencées avec leurs essieux couplés à un moyen pour faire osciller les essieux ;
lesdits essieux du premier ensemble de brosses sont suspendus dans le châssis (3) qui est pourvu de trous pour recevoir les extrémités des brosses et permettre un mouvement linéaire des essieux, où les premières extrémités des essieux du premier ensemble de brosses s'étendent vers une première poutre (5) pourvue d'un premier système de transmission (6) connecté à un premier moteur (7), dans lequel la première poutre est positionnée sur le premier côté extérieur du châssis et étant mobile par rapport au châssis ; et
lesdits essieux du second ensemble de brosses (2) sont suspendus dans le châssis (3) qui est pourvu de trous pour recevoir les extrémités des brosses (2) et permettre un mouvement linéaire des essieux, où les secondes extrémités des essieux du second ensemble de brosses (2) s'étendent jusqu'à une seconde poutre (8) pourvue d'un second système de transmission connecté à un deuxième moteur (9), dans lequel la seconde poutre (8) est positionnée sur le second côté extérieur du châssis (3) et étant mobile par rapport au châssis (3) ;
dans lequel lesdites première (5) et seconde (8) poutres sont mobiles avec un mouvement oscillatoire linéaire le long de l'axe des premier et second ensembles de brosses, ledit mouvement oscillatoire linéaire étant permis par un premier (10) et un second (11) système d'entraînement excentrique couplé à un troisième moteur (12).

2. Appareil selon la revendication 1, dans lequel les systèmes d'entraînement excentriques (10, 11) sont montés sur le châssis sous les première (5) et seconde (8) poutres.

3. Appareil selon la revendication 1 ou 2, dans lequel le premier système d'entraînement excentrique (10) monté sur le châssis sous la première poutre (5) est pourvu d'un premier essieu moteur connecté au troisième moteur, ledit premier essieu moteur étant en outre pourvu d'une première roue dentée et d'une chaîne qui s'étend à travers le châssis (3) pour venir en prise avec une seconde roue dentée sous la seconde poutre, ladite seconde roue dentée étant connectée à un second essieu moteur faisant partie du second système d'entraînement excentrique (11) monté sur le cadre (3) sous la seconde poutre (8).

4. Appareil selon l'une quelconque des revendications 1 à 3, dans lequel d'autres roues dentées sont prévues sur le châssis pour venir en prise avec la chaîne.

5. Appareil selon l'une quelconque des revendications 1 à 4, dans lequel le châssis (3) est pourvu de trous pour recevoir la chaîne.

6. Appareil selon l'une quelconque des revendications 1 à 5, dans lequel les premier et second ensembles de brosses (1, 2) tournent dans le sens contraire.

7. Appareil selon l'une quelconque des revendications 1 à 6, dans lequel le dispositif de rinçage des plaques d'impression avec du solvant comprend une pompe qui fournit le solvant pour le traitement des plaques d'impression lors de la rotation des premier et second ensembles de brosses (1, 2), ladite pompe étant connectée à une pluralité de conduits ou gicleurs agencés au-dessus des brosses parallèlement aux arbres de ceux-ci.

8. Appareil selon l'une quelconque des revendications 1 à 7, dans lequel l'appareil est en outre pourvu d'une unité de refroidissement.

9. Appareil selon l'une quelconque des revendications 1 à 8, dans lequel l'appareil est en outre pourvu d'un système de rinçage/nettoyage pour améliorer davantage le traitement des plaques après traitement par les premier et second ensembles de brosses rotatives (1, 2).

10. Appareil selon l'une quelconque des revendications 1 à 9, dans lequel le moyen pour acheminer les plaques d'impression à traiter à travers l'appareil est un système à chaîne suspendu dans la direction d'acheminement des plaques et sur lequel une barre à broches peut être montée, ladite barre à broches étant fixée à la plaque à traiter pendant le processus et retirée ensuite.
